# EUROPEAN PATENT APPLICATION

(11) **EP 4 779 820 A1**
(43) Date of publication of application: **22.07.2026**
(21) Application number: 25152317.1
(22) Date of filing: 16.01.2025
(51) Int. Cl.: H01S 3/09, H03K 3/57

(54) **CIRCUIT FOR PUMPING AN ACTIVE MEDIUM OF A LASER**

(71) Applicant: Fotona d.o.o., 1000 Ljubljana (SI)
(72) Inventor: JERAJ, Primoz, 1227 Vodice (SI); NENDL, Janko, 1000 Ljubljana (SI)
(74) Representative: Bardehle Pagenberg Partnerschaft mbB Patentanwälte Rechtsanwälte

(57) **Abstract**

The present invention relates to a circuit for pumping an active medium of a laser, wherein the circuit is adapted to generate pumping voltage pulses by summing at least two mutually time-shifted voltage pulses, and to apply the pumping voltage pulses to a pump for pumping the active medium of the laser. The present invention also relates to a laser comprising such circuit.

## Description

### 1. Field of the invention

The present invention relates to a circuit for pumping an active medium of a laser, in particular a solid-state laser.

### 2. Technical Background

Solid state lasers are employed in various medical procedures, including dermatology, dentistry, gynaecology and others. For successful operation of such lasers, energy needs to be delivered to the active medium of the laser (lasing medium) via a pumping mechanism that may include, e.g., diode pumping, optical pumping or electrical pumping. To deliver energy to the active medium, specialized circuits are needed so that power is precisely controlled to limit output laser energy deviations with potentially harmful effects to the patient.

A pulse forming module of a power supply of a laser usually consists of a large storage capacitor or multiple storage capacitors connected in series and/or in parallel. The storage capacitor(s) is/are typically charged to a voltage between 100 and 1500 Volts (V) and comprise(s) a (total) capacitance in the range from 100 microfarad to tens of millifarad. Energy is transferred from the storage capacitor(s) to the pumping mechanism, i.e., a pump such as a flashlight, and in turn to the active medium of the laser by means of an electronic switch such as an insulated gate bipolar transistor (IGBT), a metal-oxide-semiconductor field-effect transistor (MOSFET), a junction field-effect transistor (JFET), a bipolar junction transistor (BJT), a gate turn-off (GTO) thyristor etc. Storage capacitor(s) is/are discharged into the pump, which, e.g., in the case of a pump in the shape of a flashlight produces intense light which is used to pump the active medium.

Usually, output energy and peak power of a laser are regulated by changing the initial voltage on the storage capacitor(s) and/or adjusting the pulse width of the discharge. While powering the pump and/or the active medium, the storage capacitor(s) is/are discharging at a much higher rate than it is/they are charging. This results in decaying power being applied to the pump. This is especially problematic when the main discharge consists of a train of several pulses spaced a few milliseconds apart. Since the storage capacitor(s) is/are unable to fully recharge in the short time window(s) between pulses, the last pulse in a pulse train might have less than half the energy of the first pulse of the pulse train. Generally, this results in decaying laser energy for each subsequent laser pulse. While the characteristics of this decaying effect can be quantized if and when the characteristics of the storage capacitor(s) (e.g., capacitance) and the pump are known, this is unfavourable for many reasons. As the pump's characteristics can change during use, e.g., because of increasing temperature, so can the discharge curve of the storage capacitor(s). This in turn translates to deviations in output energy. Moreover, such approach may limit the use of pulses of different amplitudes in quick succession. As the storage capacitor(s) can be neither quickly charged nor discharged without discharging through the pump, it is not possible to significantly change the pulse energy from pulse to pulse. Rather, each subsequent pulse amplitude always follows the discharge curve. As such, it is for example impossible to have a high amplitude pulse followed by a lower amplitude pulse with a pause in the range of few milliseconds to tens of milliseconds when using a single switching element.

### 3. Summary of the invention

In view of the described shortcomings of the prior art, the objective of the present invention is to be able to generate variously shaped pulses with different amplitudes even in quick succession with idle times in the range of just few ten microseconds or even less. Another objective of the present invention is to render the amplitude of the pulses independent of the storage capacitor(s) discharge rate.

The above objectives are at least partially met by a circuit for pumping an active medium of a laser, wherein the circuit is adapted to generate pumping voltage pulses by summing at least two mutually time-shifted voltage pulses and to apply the pumping voltage pulses to a pump for pumping the active medium of the laser.

The pump may comprise, e.g., a flashlamp.

A single voltage pulse is usually characterized by a short positive or negative voltage rise and a subsequent drop back to zero shortly thereafter. For simplification purposes hereinafter, a single voltage pulse may be represented as a rectangular function taking a peak amplitude value during its pulse duration and zero otherwise.

According to the present invention, at least two voltage pulses are mutually time-shifted. This means that their respective rectangular representations do not completely overlap. In fact, they may overlap partially or may not overlap at all. In the latter case, by means of a summing operation, two distinct pumping voltage pulses are generated.

Summing operations in the sense of the present invention are not restricted to pairs of mutually time shifted voltage pulses. It is possible to have several voltage pulses forming a train of voltage pulses, the train of voltage pulses being added to another train of voltage pulses. As in the case of a single pair of voltage pulses, at least two voltage pulses of each train should be mutually time-shifted, meaning they do not completely overlap.

It should be noted that this aspect of the invention does not require the mutually time-shifted voltage pulses to have the same pulse length, amplitude and/or, if there are several voltage pulses forming a train, the same frequency. However, in many cases it may be desirable to have equal pulse lengths, equal amplitudes and/or equal frequency. In this case, summing operations may be used to create pumping voltage pulses that have desirable features that may be impossible to obtain by taking a single voltage pulse or a single train of voltage pulses.

Generally, circuits according to the present invention may comprise, or be functionally coupled to, control logic that controls, e.g., using control signals (details below), operation of the respective circuit's components, in particular operation of any one or more switching element(s) of the respective circuit (details below). For example, the control logic may be adapted to operate one or more switching elements such as to generate any number (e.g., single voltage pulses or trains of two or more voltage pulses) and/or shape (e.g., in terms of pulse length and/or amplitude) of voltage pulses, e.g., using a respective switching element.

By summing two mutually time-shifted pulses, higher repetition rates of pulses or a train of pulses can be obtained. For instance, if both pulses are generated by different sub-circuits or different switching elements, the common technical restrictions of single electric components can be overcome. Thus, high voltages may be used, yet allowing for the use of switching elements comprising a low or medium operating frequency. In the case of regular pulse (train) patterns, shifting one of the inputs by (approximately) half a repetition rate (thus obtaining a mutual time shift between the pulses) will lead to a doubling of the frequency of the respective outcome. By adding more than two pulses or trains of pulses, even higher repetition rates can be obtained.

Throughout this disclosure, including in the claims, quantities and/or ratios are to be understood as approximate expressions. Generally, a quantity and/or a ratio as stated may be understood to refer to a range of ±20%, preferably to a range of ±10%, more preferably to a range of ±5%, most preferably to a range ±1% around the quantity and/or ratio as stated.

For example, a first quantity Q1 and/or ratio being the same as a second quantity and/or ratio Q2 may refer to a range for Q1 between 0.8·Q2 and 1.2·Q2, preferably between 0.9·Q2 and 1.1·Q2, more preferably between 0.95·Q2 and 1.05·Q2, most preferably between 0.99·Q2 and 1.01·Q2, and/or to a range for Q2 between 0.8·Q1 and 1.2·Q1, preferably between 0.9·Q1 and 1.1·Q1, more preferably between 0.95·Q1 and 1.05·Q1, most preferably between 0.99·Q1 and 1.01·Q1.

For example, a first quantity Q1 and/or ratio being double a second quantity and/or ratio Q2 may refer to a range for Q1 between 1.6·Q2 and 1.4·Q2, preferably between 0.8·Q2 and 1.2·Q2, more preferably between 0.9·Q2 and 1.1·Q2, most preferably between 0.98·Q2 and 1.02·Q2.

For example, a first quantity Q1 and/or ratio being half a second quantity and/or ratio Q2 may refer to a range for Q1 between 0.4·Q2 and 0.6·Q2, preferably between 0.45·Q2 and 0.55·Q2, more preferably between 0.475·Q2 and 0.525·Q2, most preferably between 0.495·Q2 and 0.505·Q2.

For example, a first quantity Q1 and/or ratio being a quarter of a second quantity and/or ratio Q2 may refer to a range for Q1 between 0.2·Q2 and 0.3·Q2, preferably between 0.225·Q2 and 0.275·Q2, more preferably between 0.2375·Q2 and 0.2625·Q2, most preferably between 0.2475·Q2 and 0.2525·02.

For example, a first quantity Q1 and/or ratio being an eighth of a second quantity and/or ratio Q2 may refer to a range for Q1 between 0.1·Q2 and 0.15·Q2, preferably between 0.1125·Q2 and 0.1375·02, more preferably between 0.1175·Q2 and 0.13125·Q2, most preferably between 0.12375·Q2 and 0.12625·Q2.

Preferably, summing is performed, at least in part, by means of at least two magnetically coupled inductors. Hereinafter, it is to be understood that coupled inductors may refer to a configuration in which the inductors are (exclusively) magnetically interconnected, or to a configuration in which the inductor windings are (exclusively or additionally) physically interconnected or even share a common winding (the latter configuration may also be termed an autotransformer). In any case, the magnetic interconnection of coiled electric wire is exploited. While one of the two coupled inductors may be subject to a voltage pulse, the other of the two coupled inductors may be subject to an equivalent voltage induced via the magnetic flux of the first of the two coupled inductors.

Such summing operation proves to be very advantageous as a voltage pulse generated in one inductor will be instantaneously "mirrored" to the other inductor coupled to said inductor, without the need for separately generating this latter voltage pulse within a sub-circuit of this second inductor.

Preferably, the coupled inductors comprise opposite windings. In the case of only two inductors, one normal vector of an inductor's winding is opposite to the other normal vector of the other inductor's winding. Subsequently, the voltage (set) on one side of one of the coupled inductors will be opposite to the voltage induced on the other side of the other of the coupled inductors. This is technically useful because, according to the law of Faraday, the current induced in a secondary coil by magnetic flux of a first coil is opposite to the voltage of the first coil. Thus, both currents are directed to the same direction which is the direction of the pump.

In the case of coupled inductors comprising two entry poles and one exit pole, the resulting output voltage is (approximately) half of the sum of the input voltages. If two non-overlapping voltage pulses of equal amplitude are summed in this manner, the result comprises two voltage pulses, each comprising an amplitude of (approximately) half of the input voltage amplitude. Thus, a summing operation of this type reduces the voltage ripple, as the output voltage pulses are only (approximately) half of their amplitude compared to the case of them being summed directly (e.g., by a mere parallel configuration of two sub-circuits).

In an example, the circuit is adapted to generate the pumping voltage pulses by summing first and second mutually time-shifted voltage pulses, the first mutually time-shifted voltage pulses by summing third and fourth mutually time-shifted voltage pulses, and the second mutually time-shifted voltage pulses by summing fifth and sixth mutually time-shifted voltage pulses. That is, the first voltage pulse(s) result(s) from a summing operation of the third and fourth time-shifted voltage pulses, the second voltage pulse(s) result(s) from a summing operation of the fifth and sixth voltage pulses. Thereafter, the first and second voltage pulses are summed to generate the pumping voltage pulses. It can therefore be seen that two voltage pulses each, or possibly two trains of voltage pulses each, are summed in couples. There may be a control logic that controls, e.g., using control signals, operation of the circuit and/or its components, in particular of its switching element(s), to generate the respective trains of voltages pulses. However, this is not exhaustive. It may be possible that other voltage pulses are added in at least one of the summing operations. It may also be possible that several couples of mutually time-shifted voltage pulses or trains of voltage pulses are added before undergoing another summing operation. This aspect of the invention is not limited to only six voltage pulses or six trains of voltage pulses. For example, it is possible that the mentioned voltage pulses each result from prior summing operations featuring a plurality of distinct voltage pulses.

In this aspect, the invention comprises a "second level" of summing operations where the third and fourth as well as the fifth and sixth voltage pulses are added. There is also a "first level" of summing operations where the first and the second voltage pulses are added. However, this aspect is not limited to only two levels of summing operations. As pointed out above, it is possible that there is a third level before the second level from which the third, fourth, fifth and sixth voltage pulses result. It would also be possible that, after the first and the second voltage pulses are added, another summing operation with yet other voltage pulses takes place as to generate the pumping voltage pulses.

By using a plurality of such levels and taking carefully chosen mutually time-shifted voltage pulses as inputs, even higher repetition rates of resulting pumping voltage pulses can be obtained. If every summing operation takes two inputs, it is, for instance, possible to (approximately) double the repetition rate of (resulting) voltage pulses at every level. In this case, a three-level set-up could be used to increase the repetition rate of voltage pulses by a factor of eight, i.e., to generate pumping voltage pulses with a repetition rate eight times the repetition rate of voltages pulses entered at the third level of summing. Similarly, by choosing appropriate summing elements, the voltage ripple of the pumping voltage pulses can be reduced up to the same factor.

A more specific example of the preceding descriptions may require that summing the first and second mutually time-shifted voltage pulses is performed by means of a first pair of magnetically coupled inductors and summing the third and fourth mutually time-shifted voltage pulses is performed by means of a second pair of magnetically coupled inductors. Furthermore, summing the fifth and sixth mutually time-shifted voltage pulses may be performed by means of a third pair of magnetically coupled inductors. In this specific example, the respective inductors of each pair of magnetically coupled inductors are directly wire-connected to each other.

This means that, for any of these summing operations, two inputs and one output may be distinguished. Input may in this sense refer to the side of coupled inductors which is oriented toward the high side of a voltage source of the circuit. Accordingly, output may refer to the side which is oriented to the pump which is the principal consumer (or load) of the circuit. Having two inputs means that one of the coupled inductors may be part of a different sub-circuit than the other coupled inductor. For instance, one sub-circuit may be used to generate a first voltage pulse and another sub-circuit may be used to generate a second, time-shifted voltage pulse. If both pulses do not overlap, the output may be two distinct voltage pulses, each comprising an amplitude of (approximately) one half of the input voltage pulse amplitude (this may refer to the case that both inductors have the same inductance and are ideally coupled). It is recalled that a pair of magnetically coupled inductors may, throughout this disclosure, also include autotransformers where both inductors have a common winding and the common winding may comprise a middle point.

The requirement of direct wire-connection may refer to both inductors being physically connected to each other at their output (low side of a voltage source). No other electric device may be connected in between (in this sense, cables, wires and other materials solely serving to connect two electric components are not seen as electric devices). This requirement may amount to the condition that one side of the one inductor has the same electric potential than the other side of the other inductor. These sides may typically be oriented to the same side of/within the circuit as both inductors may usually comprise opposite windings.

As outlined in the example above, there may be two levels of summing operations, the second summing level comprising two pairs of coupled inductors, the first level only comprising a single pair of coupled inductors. This way, four mutually time-shifted voltage pulses (third, fourth, fifth and sixth) can be seen as the inputs to the second level and, resulting therefrom, two mutually time-shifted voltage pulses can be seen as the inputs to the first level. By summing the latter, the pumping voltage pulses may result directly or after carrying out further operations.

In another example, the circuit is further adapted to generate the pumping voltage pulses by summing first, second, third and fourth mutually time-shifted voltage pulses using two pairs of magnetically coupled inductors. In this situation, summing first and second mutually time-shifted voltage pulses is carried out by means of a first pair of magnetically coupled inductors and summing third and fourth mutually time-shifted voltage pulses by means of a second pair of magnetically coupled inductors. In this case, the respective inductors of each pair of magnetically coupled inductors may be directly wire-connected to each other.

This does not require more than one summing level. However, two pairs of magnetically coupled inductors are proposed to carry out two parallel summing operations for respectively two of the four voltage pulses. For this purpose, the explanations for the coupled inductors above remain valid. Especially, the coupled inductors may be autotransformers, too. The respective outputs of the pairs of coupled inductors need not be summed again but the two pairs of coupled inductors can be interconnected on their low sides or each of the pairs of coupled inductors may be connected to a different pole of the pump.

The first case refers to an example wherein the four inductors of the two pairs of magnetically coupled inductors are directly wire-connected to each other. Then, the circuit may be further adapted to generate the first and the third voltage pulses by summing fifth and sixth mutually time-shifted voltage pulses by means of a third pair of magnetically coupled inductors. Also, the second and the fourth voltage pulses are generated by summing seventh and eighth mutually time-shifted voltage pulses by means of a fourth pair of magnetically coupled inductors. In this example, a first inductor of the third pair is connected to a first inductor of the first pair and a second inductor of the third pair is connected to a first inductor of the second pair. Furthermore, a first inductor of the fourth pair is connected to a second inductor of the first pair and a second inductor of the fourth pair is connected to a second inductor of the second pair.

Such circuit may produce four mutually time-shifted voltage pulses. This may be achieved by using four sub-circuits each containing a switching element. The four (fifth, sixth, seventh and eighth) mutually time-shifted voltage pulses may be summed in pairs. Different from the embodiment discussed further above, however, the pairs of coupled inductors used for the operation may not be directly wire-connected to each other. The third and fourth pairs of coupled inductors may be seen to comprise two inputs and two outputs each. Each inductor of each of the third and fourth pairs of coupled inductors may be connected to a different subsequent pair of coupled inductors. These latter pairs of coupled inductors may meanwhile be respectively directly wire-connected to each other. They may be autotransformers.

This circuit advantageously reduces the electric currents in the coils of the inductors as compared to the situation where coupled inductors are directly (wire-)connected to each other. In the latter case, the electric currents in the inductors of the second level are added before entering into the first level of summing operations. Electric current may be critical for dimensioning the inductors, in particular with regards to the core material. So, the first-level inductors may need to be adapted to withstand higher currents which may require less windings and/or larger/better core material. By using a circuit as just described, this effect can be mitigated as no current summing is effectuated at the second level of summing operations. Thus, the current in the second level is reduced compared to the example solely using directly wire-connected inductors

In a different example, the circuit is adapted to generate any of the first, second, third and/or fourth mutually time-shifted voltage pulses by summing at least two respective further mutually time-shifted voltage pulses by means of a respective further pair of magnetically coupled inductors, wherein respective inductors of the respective further pair of magnetically coupled inductors are directly wire-connected to each other. Such circuit requires eight voltage pulses to be generated which serve as inputs to four pairs of magnetically coupled inductors representing the second level of summing operations. The outputs of the pairs of magnetically coupled inductors are the first, second, third and fourth mutually time-shifted voltage pulses. Two of these four mutually time-shifted voltage pulses may be summed by means of a respective pair of magnetically coupled inductors, wherein respective inductors of each pair of magnetically coupled inductors are directly wire-connected to each other. Autotransformers may be used. However, this is not necessary. This is the first level of summing operations.

It may be advantageous to adapt the circuit such that half of the magnetically coupled inductors are connected to one pole of the pump, whereas the other half of the magnetically coupled inductors are connected to the other pole of the pump. Both levels of summing operations are then to be found on both sides of the pump. Specifically, three pairs of coupled inductors may be connected to one side of the pump (e.g. high side of a voltage source), comprising two levels of summing operations, whereas another three pairs of coupled inductors may be connected to the other side of the pump (low side of the voltage source), also comprising two levels of summing operations. Other arrangements are possible. In any case, this circuit set-up allows for the use of eight phases of voltage pulses in the second summing level. With no overlap between these voltage pulses, the result is a train of at least eight pumping voltage pulses with certain physical characteristics that may be difficult or impossible to generate by a single circuit as known in the prior art.

In some examples, the mutually time-shifted voltage pulses may be generated by discharging a source voltage into one of the coupled inductors used for summing operations. Furthermore, a respective, separate switching element and a respective, separate rectifying element may be used for effecting this discharge. Only the coupled inductors closest to the voltage source (e.g., on the highest level of summing operations) may require switching and rectifying elements. These coupled inductors may be, by means of switching elements, connected to the high or low side of the voltage source. There may be no further summing elements in between these inductors and the voltage source. Preferably, the source voltage is provided by one or more capacitive elements (connected in parallel or in series), such as electrolytic capacitors.

Switching elements may be of diverse types. A switching element may be a simple switch that can be manually operated. However, preferably, electric switches may be used. They may be implemented as transistors or comparable electric components. It is common to use insulated-gate bipolar transistors (IGBTs), thyristors, gate-turn-off thyristors (GTO) or metal oxide semiconductor field-effect transistors (MOSFETs).

Similarly, rectifying elements may be active or passive. An example of the latter is a diode. Active elements may be one of the switching elements mentioned above, which means they may be operated to change their conductivity properties.

An important advantage of the present invention is that, by using several distinct switching elements and subsequently summing their outputs, much higher pulse frequencies than with a single switching element may be reached for a given voltage. Switching elements may have different switching rates, but often higher switching rates come at the cost of lower admissible voltages.

Another advantage of circuits according to the present invention is that they may function without a smoothing capacitor switched in parallel to the pump and/or without a smoothing inductor switched in series with the pump. This is, at least in part, due to a reduced voltage ripple as described above. It may be noted that switching and rectifying elements are used in DC-DC, or buck, converters. Hence, the arrangement in this invention might resemble a buck converter, or a parallel arrangement of multiple buck converters. However, apart from one or several capacitors that may serve as primary voltage source of the circuit, no further capacitors are required. In particular, no capacitor is required to be switched directly in parallel to the load, i.e., the pump. Such capacitor might even be disadvantageous as voltage pulses would be smoothened, hence losing their pulse character. Also, as voltage would be continuous across the capacitor, the voltage pulses may not reach the desired amplitude during a pulse length. It is worth pointing out that a voltage source comprising one or more storage capacitors may be considered "in parallel" with the pump. However, in this capacity, these one or more storage capacitors have no smoothing effect. To the contrary, they are used to generate short but intense pulses. The term smoothing capacitor refers to an element which has a more passive role, only serving as a voltage source if the primary voltage source is disconnected. It should also be noted that a capacitor that only comes into use as a safety element of the circuit, preventing any undesired and potentially harmful discharge into the pump, may not be considered to be a smoothing capacitor.

The same reasoning applies to (the absence of) a smoothing inductor. Apart from the inductors used to perform summing operations, no further inductors may be required. In particular, it may not be desirable to have a constant or close to constant electric current within the pump. This would be the case, e.g., if an inductor with a large inductance was connected in series with the pump.

The circuit according to the invention may comprise at least one safety element. Such safety element may be a device functioning as an electric circuit breaker for preventing an uncontrolled discharge of a voltage source into the pump and/or the active medium. Such safety element may serve as a security for the pump. It is not desired that a voltage source discharges in an uncontrolled way into the pump. This could not only lead to harm to the patient due to resulting, uncontrolled emission of laser pulses, but to serious damage of electric components, too. However, this may occur, e.g., when a switching element encounters a malfunction, e.g., when a switching element fails to reopen. A safety element as just described may mitigate this risk.

There are several possible examples of a safety element as just described. For example, it may be a passive element such as a fuse. Others might rely on magnetic circuit breaking. However, it is not necessary that the safety element physically interrupts or breaks the circuit. It may be sufficient that another load takes on the discharge without the need for a physical interruption of the circuit comprising the pump.

Another possible implementation of an electric component serving as electric circuit breaker (although not physically opening the circuit) is one or more capacitors switched in parallel to the switching and the rectifying element of one of the coupled inductors. Under regular conditions, this type of safety capacitor will be fully charged. In the case of a malfunction of one of the respective switching elements, the safety capacitor may be discharged, thus preventing a direct discharge of a voltage source into the pump. In fact, the safety capacitor has a smaller capacity than the voltage source (e.g. capacitor bank). So, given the same voltage, a discharge of the safety capacitor is much less problematic than, otherwise, a discharge of (half of) a capacitor bank serving as voltage source. This is because the energy set free in the first case is much less than the energy in the second case. The latter approach may be advantageous when there is a common voltage source that comprises two or a multiple of two capacitive elements to either side of a middle point. In this case, the safety component may be represented by two RC-sub-circuits with a common resistive element connected to the middle point of the voltage source. It is possible to use one or several capacitors for every sub-circuit. In the case of a switching-element failure, only one of the safety capacitors will discharge into the pump, but not the entire voltage source. The latter may comprise a charge several times higher than the combined safety capacitors. For example, when subject to equal voltage, the safety capacitor has a smaller or much smaller capacitance.

As stated before, single electric components such as switching elements have limitations as to their switching frequency and voltage/current limitations. It is an aim of the present invention to overcome these limitations by using several switching elements in an advantageous set-up. Before any summing operations, a voltage pulse may have a pulse length of less than 200 microseconds. The common voltage source may have a voltage between 100 and 1500 V. The switching elements may comprise a maximum switching frequency of no more than 100 Kilohertz (KHz). By means of the present invention, pumping voltage pulses can be produced that exceed a frequency of 100 KHz. In some arrangements, especially in the presence of coupled inductors, the amplitude of pumping voltage pulses may be reduced.

For example, circuits according to the present invention may be adapted such that a ratio between an amplitude of the mutually time-shifted voltage pulses and an amplitude of the pumping voltage pulses may be an integer multiple, preferably an integer multiple of two or three. Additionally or alternatively, circuits according to the present invention may be adapted such that a ratio between a period of the mutually time-shifted voltage pulses and a period of the pumping voltage pulses may be an integer multiple, preferably an integer multiple of two or three. As explained above, depending on parameters, magnetically coupled inductors may (approximately) halve the amplitude of their inputs. Thus, as compared to the inputs, the output of the coupled indictors may comprise voltage pulses of same pulse length and occurrence, but of (approximately) half the amplitude. As a result of a multi-level summing operation, the amplitude of the pumping voltage pulses may be lessened by two or any power of 2 vis-à-vis the amplitudes of the mutually time-shifted voltage pulses based on which they are generated.

In some examples, circuits according to the present invention may be adapted such that each of the mutually time-shifted voltage pulses may be part of a train of voltage pulses, two trains of voltage pulses each being mutually phase-shifted. There may be a control logic that operates the circuit and/or its components accordingly. A train of voltage pulses may be understood as comprising at least two voltage pulses. In the presence of two voltage pulses, a frequency may be determined. In the presence of more than two voltage pulses in a train, a frequency may be determined by counting the number of single pulses over a given time lapse. It may be preferable if the voltage pulses are spaced regularly, i.e., in an equidistant manner in time, because their frequency may then simply be determined as the inverse of the voltage pulse period. It may also be preferable if trains of voltage pulses comprise the same voltage pulse period. In this case, defining a phase shift is straight-forward. However, none of this is strictly necessary. For example, it may be possible that two trains of voltage pulses are phase-shifted if they follow a same pattern of voltage pulses over time but one of the trains of voltage pulses is delayed with respect to the other. Note that interposition and temporal coincidence (as in temporal overlap) of trains of voltage pulses do not imply that their individual voltage pulses need to overlap. In some cases, it may be desirable that none of the voltage pulses of any of the trains of voltage pulses overlap.

It should be noted that the reference to two trains of voltage pulses is not exhaustive. It may be the case that three trains of voltage pulses are summed (simultaneously). There may also be a series of summing operations across one or several levels. However, in order to carry out a summing operation, at least two trains of voltage pulses or one train of voltage pulses and another single voltage pulse may be required.

In some examples, a frequency of a mutually phase-shifted first and second train of voltage pulses may be (approximately) double a frequency of a third and fourth and/or fifth and sixth mutually phase-shifted train of voltage pulses. Each of these respective trains of voltage pulses may have an identical frequency and may be regular in the sense that it comprises a constant and identical pulse period. Most preferably, two trains may be mutually phase-shifted by (approximately) half a pulse period. If such trains are summed, the resulting train comprises (approximately) double their frequency. However, these conditions are not strictly necessary.

In one example, the first, second, third, fourth, fifth and sixth mutually time-shifted voltage pulse may be part of a respective first, second, third, fourth, fifth and sixth train of voltage pulses, wherein the third, fourth, fifth and sixth train of voltage pulses comprise (approximately) a same repetition period and are mutually phase-shifted by (approximately) an integer multiple of one quarter of the repetition period. It is important to understand that, in this specific case, the phase-shift may require that the integer is not any multiple of four, since, otherwise, there wouldn't be any true phase shift.

Of course, the invention is not restricted to summing of only two trains of voltage pulses. It is well possible to obtain a first train of voltage pulses by summing a third and fourth train of voltage pulses and, likewise, obtaining a second train of voltage pulses by summing a fifth and a sixth train of voltage pulses. If the first and second train's pulse frequency is identical, their sum can yield another train of voltage pulses comprising a frequency twice as high as the first and second train's frequency and four times as high as any of the frequencies of the third, fourth, fifth and sixth's train of voltage pulses. The sum of the first and second train of voltage pulses may serve as pumping voltage pulses for the pump or a pumping medium. However, further operations may be carried out on the first and second train of voltage pulses before they are supplied to the pump. The number of summing operations in parallel and in series is not limited.

Another example may be a circuit where the first, second, third and fourth mutually time-shifted voltage pulses are part of a respective first, second, third and fourth train of voltage pulses, wherein the first, second, third and fourth train of voltage pulses comprise (approximately) a same repetition period and are mutually phase-shifted by (approximately) an integer multiple of one eighth of the repetition rate. Here, again, a real phase shift may require the integer to be different to a multiple of eight as, otherwise, there would not be any true phase-shift.

Throughout this disclosure, the term phase shift is meant to only refer to such true phase shifts, which amounts to the condition that the trains may not overlap due to a phase shift by a multiple of a pulse train period.

In another aspect, the present invention relates to a laser comprising an electric circuit as described above. Such laser may deliver particularly advantageous laser pulses as may be derived from the above.

In a further aspect, the present invention relates to a pumping system for a laser, wherein the pumping system comprises a circuit as described throughout this disclosure and a pump for pumping an active medium of the laser which pump receives pumping voltage pulses from the circuit. That is, a pumping system for a laser may comprise a pump (e.g., a flashlamp) for pumping an active medium of the laser, and a circuit that is adapted to generate pumping voltage pulses by summing at least two mutually time-shifted voltage pulses and to apply the pumping voltage pulses to the pump. Again, all that is described throughout this disclosure with reference to a circuit according to the present invention may equally apply to such a pumping system for a laser, and in particular to its circuit.

### 4. Short description of the figures

- **Fig. 1:**: Illustration of a circuit according to the present invention using four phase-shifted switching sub-circuits in parallel and a two-level summing cascade featuring three summing elements;
- **Fig. 2a:**: Illustration of control signals and resulting key voltages V1 - V7 in the circuit according to Fig. 1 (fixed pulse length of control signals for switching elements SW1 - SW4; no overlap of respective pulses);
- **Fig. 2b:**: Illustration of control signals and resulting key voltages V1 - V7 in the circuit according to Fig. 1 (variable pulse length of control signals for switching elements SW1 - SW4);
- **Fig. 3:**: Illustration of a circuit according to the present invention using four phase-shifted switching sub-circuits in parallel and a two-level summing cascade featuring four summing elements;
- **Fig. 4:**: Illustration of a circuit according to the present invention using four phase-shifted switching sub-circuits for the high side of a capacitor bank and four phase-shifted switching sub-circuits for the low side of the capacitor bank.

### 5. Detailed description of the figures

For the sake of brevity only a few examples will be described in the following. The skilled person will recognize that the specific features described with reference to these examples may be modified and combined differently and that individual features may also be omitted if they are not essential. The general explanations in the sections above are also valid for the following more detailed explanations.

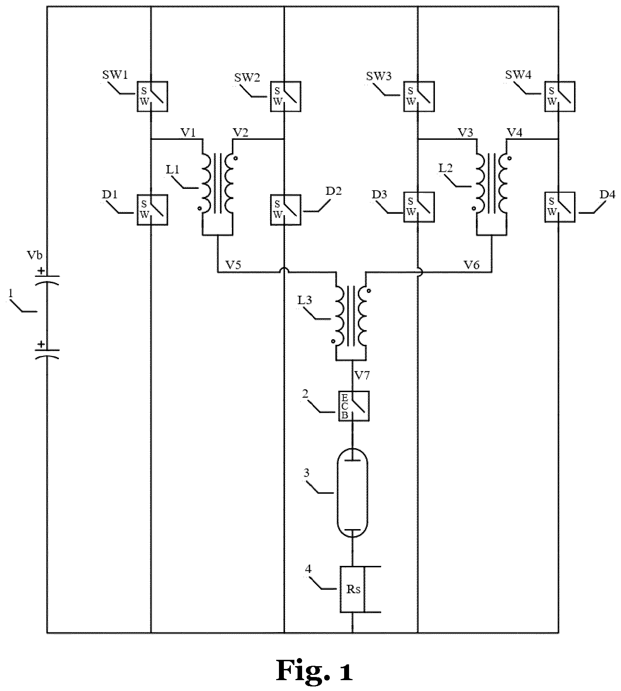

Fig. 1 illustrates a circuit with three pairs of magnetically coupled inductors, wherein the coupled inductors of a pair are respectively directly wire-connected to each other (output side of the coupled inductors). This type of coupled inductors may also be referred to as summing transformers.

A source voltage is delivered by a capacitor bank 1 represented by two capacitors connected in series. The source voltage is marked Vb. Capacitor bank 1 functions as a voltage source for four distinct but essentially identical sub-circuits switched in parallel.

Each of the sub-circuits comprises an electronic switching element, respectively marked SW1, SW2, SW3 and SW4. These elements are switched with a very high frequency in the range of few tens of KHz to hundred KHz or even higher. Various switching elements may be used, from IGBT, MOSFET, JFET to GTO thyristors or power BJT. When selecting switching elements, the most important parameters to be considered may be operating frequency, voltage rating, current rating and dissipation losses.

Like switching elements, each of the identical four sub-circuits comprises a rectifying element marked D1, D2, D3 and D4 connected between the respective switching element and the low side of capacitor bank 1. As rectifying elements, passive diodes with appropriate current and voltage ratings may be used or even synchronous rectifier elements to further improve efficiency at the cost of circuit complexity. In the example of Fig. 1, active (electric) switching elements are present.

In between the switching and the rectifying element of any of the four sub-circuits an induction element is connected. Two of the induction elements are respectively coupled to form a summing transformer comprising opposite windings. The first and second circuit's inductive elements form a pair of coupled inductors L1. For even current sharing between each of the four sub-circuits a high coupling coefficient of 0.95 or higher may need to be achieved, where 1.0 represents ideal coupling at which 100% of all generated magnetic flux from one coil passes through the other. An effective approach for increasing the coupling factor is using twisted pairs cables for the windings. In Fig. 1, as per common convention, dots mark where current enters the respective coil, meaning the voltage will be positive at the dot of the respective other coil. Where the winding ratio (between the inductors) is 1:1, the voltage across the primary winding will be the same as across the secondary winding.

The respective voltage inputs (measured in between switching elements SW1 - SW4 and rectifying elements D1 - D4 of the first and second sub-circuits) are marked V1 and V2. The single output of the summing transformer is marked V5. In the same way, the input values V3 and V4 taken from the third and fourth sub-circuit enter a pair of coupled inductors, or a summing transformer, marked L2. This pair of coupled inductors yields a voltage labelled V6. Voltages V5 and V6 serve as input voltages to a third pair of coupled inductors, or a summing transformer, which is marked L3. It yields a voltage labelled V7. Between the output of this third summing transformer and the low side of the capacitor bank 1 an electric circuit breaker 2, a (light) pump 3, e.g., a flashlamp, and a current sensor 4 are connected in series. Hence, essentially voltage V7 may be assumed to lie across the pump as the electric circuit breaker may be assumed to be closed during intended use and current sensor 4 has a small resistance.

The example of Fig. 1 thus comprises three summing elements arranged in two levels. Voltage V7 may be understood to represent the pumping voltage pulses. Voltages V5 and V6 may be understood to represent first and second voltage pulses or a first and second train of voltage pulses. They result from a summing operation of V1 and V2 (representing third and fourth voltage pulses or trains of voltage pulses) respectively V3 and V4 (representing fifth and sixth voltage pulses or trains of voltage pulses). The electric circuit of Fig. 1 thus uses four phase-shifted trains of voltage pulses originating from four distinct sub-circuits.

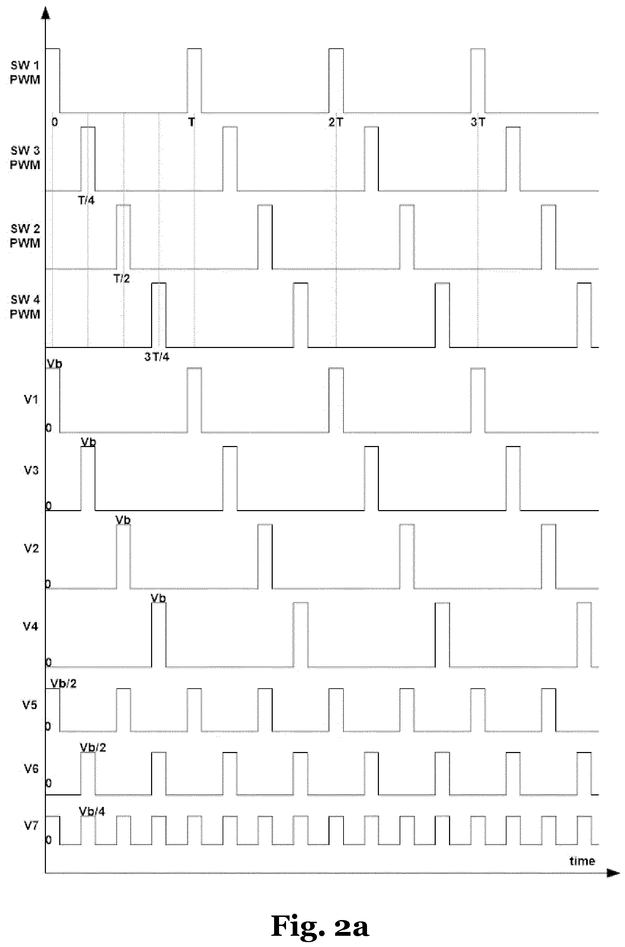

When any of switching elements SW1, SW2, SW3 or SW4 is activated (the respective time-shifted control signals are depicted in Fig. 2a, and they may be issued by a control logic comprised in, or functionally coupled to, the circuit), storage capacitor voltage is connected at the respective ends of summing elements L1 or L2. As both inductors of a pair of coupled inductors are wire-connected in the example of Fig. 1 (corresponding to the middle point of an autotransformer), the resulting voltage is equivalent to the summed voltage of both inductors, save a certain amplitude factor at any moment. The amplitude of the voltage ripple following the second level of summing operations is (approximately) half of source voltage Vb delivered by capacitor bank 1. Similarly, the resulting voltage after the first level of summing operations is (approximately) half of the sum of both input voltages (i.e., voltages input into the first level of summing operations) and (approximately) one quarter of source voltage Vb delivered by capacitor bank 1.

The summing point of the first level of summing elements (which is the output of the third pair of coupled inductors L3) is represented above electric circuit breaker (ECB) 2. ECB 2 may be a passive high-breaking fusible element or a switching element similar to the other switching elements already described. ECB 2 must be able to withstand summed current which can be relatively high. As this element is continuously conducting in normal operation, good conducting properties may be required for minimizing dissipation losses. If a failure of any of the switching elements of the sub-circuits occurs, ECB 2 breaks the circuit, thus preventing a total discharge of the capacitor bank 1 into the pump and/or active medium.

Input power to pump 3 can be monitored in real time by measuring its voltage and current. If the power deviates, e.g., beyond pre-set values, ECB 2 may be triggered. current sensor 4 is connected in series with pump 3. Current may be sensed, e.g., with the help of a shunt resistor with known resistance, magnetic field sensors and/or sensors based on Faraday's Law.

The circuit of Fig. 1 uses a high side switching topology, meaning its switching elements are connected to the positive pole of the source (capacitor bank 1) and the load (pump 3) is connected to the negative pole of capacitor bank 1. But the pump may also be operated using a low side switching topology, where the pump is connected to the positive pole of capacitor bank 1 and switching elements SW1, SW2, SW3 and SW4 are connected to the negative pole of capacitor bank 1.

Fig. 2a illustrates the control signals used to control switching elements SW1, SW2, SW3 and SW4 of the circuit shown in Fig. 1 as well as voltages V1 - V7 over time. As can be seen, all these representations relate to a single time scale marked to the x-axis and are illustrated above each other. At the top of the figure, pulse-width modulation (PWM) in switching element SW1 is shown. This translates to a train of pulses represented by rectangular shaped functions, wherein for most of the time, their value is zero. At t=0, t=T, t=2T and t=3T, a pulse is shown (T being the switching pulse period of any of switching elements SW1 - 4). As will become even clearer below, T denotes a voltage pulse period at the highest (i.e., second) level of summing operations. These pulses serve to render switching element SW1 conductive (e.g., by closing switching element SW1). At the end of a pulse, switching element SW1 is rendered nonconductive (e.g., by re-opening switching element SW1, in turn interrupting the sub-circuit).

Below the representation concerning switching element SW1, a second train of voltage pulses is shown. These pulses represent PWM in switching element SW3. These pulses are shifted by (approximately) a quarter voltage pulse period T/4 relative to the PWM in switching element SW1. The shape, amplitude and switching pulse period are otherwise identical to the PWM in switching element SW1. Accordingly, a pulse is shown at t=T/4, t= 5T/4, t=9T/4 and t=13T/4. These pulses serve to operate the switching element SW3 as has been described above with reference to switching element SW1.

Below this second representation concerning switching element SW3, PWM in switching element SW2 is shown. Again, each of the pulses has identical shape, amplitude and voltage pulse period as the pulses relating to PWM in switching elements SW1 and SW3. However, the phase is shifted by (approximately) half a period T vis-à-vis the PWM in switching element SW1 and by (approximately) a quarter period T/4 vis-à-vis the PWM in switching element SW3. Thus, the pulses occur at t=T/2, t=3T/2, t=5T/2 and t=7T/2. These pulses serve to operate the switching element SW2 as has been described above with reference to switching element SW1.

The fourth representation illustrates the control signals for switching element SW4. Again, each of the pulses has identical shape, amplitude and voltage pulse period as the pulses relating to PWM in switching elements SW1, SW2 and SW3. However, the pulses are phase-shifted by (approximately) three quarter periods 3T/4 vis-à-vis the PWM in switching element SW1, by (approximately) half a period T vis-à-vis the PWM in switching element SW3 and by (approximately) a quarter period T vis-à-vis the PWM in switching element SW2. Accordingly, the pulses occur at t=3T/4, t=7T/4, t=nT/4 and t=15T/4. The pulses serve to operate switching element SW4 as has been described above with reference to switching element SW1.

As with single switching elements, control signals for phase-shifted switching elements use pulse width modulation to get a desired output voltage as compared to an input voltage. With increasing duty cycle, meaning increasing pulse width at fixed period, the output voltage is approaching input voltage. Thus, the output voltage is adapted by operating on the control signals of the switching elements.

Each pair of switching elements SW1, SW2, SW3 and SW4 may receive control signals that are shifted by (approximately) half a voltage pulse period. Additionally, the control signal for operating a switching element for a pair of voltage pulses may be shifted by (approximately) a quarter of a voltage pulse period relatively to the control signal for operating a switching element of a different pair of voltage pulses.

Fig. 2a furthermore illustrates voltages V1-V7 that result from operating switching elements SW1, SW3, SW2 and SW4 using the PWM just described. Voltages V1, V3, V2 and V4 and correspond to the pulses of the PWM in switching elements SW1, SW3, SW2 and SW4, respectively. The amplitude of the voltage pulses comprised in voltages V1, V3, V2 and V4 is Vb, which was earlier described as the source voltage supplied by capacitor bank 1 of the circuit of Fig. 1. As for the corresponding switching element control signals, there is (approximately) a quarter period T/4 phase shift in between successively illustrated voltages V1, V3, V2 and V4. It should be noted that pairs of voltages to be summed (V1 and V2, V2 and V4) are phase-shifted by (approximately) half a period T/2.

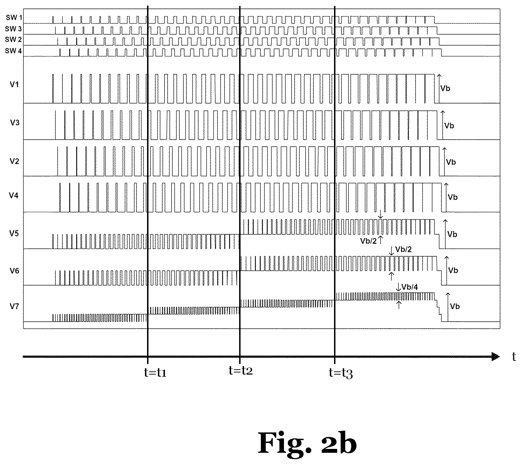

While the pulse lengths are short, there is no overlap between pulses when summing V1 and V3, V2 and V4. This results in output voltages V5 and V6 with pulses of amplitude Vb/2. Voltages V5 and V6 are illustrated below voltages V1 - V4 in Fig. 2a. If a higher output voltage was desired, longer control pulses could be chosen to create an overlap of voltages V1, V2, V3 and V4. This would result in voltages V5 and V6 from Vb/2 to Vb (see also description of Fig. 2b below). It can be seen in Fig. 2a that V5 and V6 respectively exhibit a voltage pulse whenever voltages V1 or V2 or respectively voltages V3 or V4 exhibit a voltage pulse. The frequency of the voltage pulses of voltages V5 and V6 is increased by a factor of two as compared to the frequency of the voltage pulses of voltages V1 - V4. It can also be seen that, due to the regularity of the pulse trains and their phase shift, voltages V5 and V6 are mutually phase-shifted by (approximately) a quarter period T/4.

Finally, voltage V7 is shown, which is the sum of voltages V5 and V6. Similarly to what has been described above, for short control pulses voltage V7 consists of pulses with an amplitude between 0 and Vb/4. This situation is represented here. With increasing overlap between pulses, the output (pumping) voltage may amount from Vb/4 to Vb/2 or from Vb/2 to 3Vb/4 or even from 3Vb/4 to Vb. Regardless of the chosen pulse width, the voltage ripple is similar for each summing level. Voltage V7 represents a train of regular voltage pulses of a frequency double the frequency of voltage pulses of V5 and V6, and fourfold the frequency of voltage pulses of voltages V1 - V4.

Fig. 2b illustrates another diagram relating to the circuit of Fig. 1. Again, the control signals used to control switching elements SW1, SW2, SW3 and SW4 of the circuit shown in Fig. 1 as well as voltages V1 - V7 over time are shown. The control signals for switching elements SWi - SW4 are phase-shifted in the same manner as before. This time, however, for increasing time t, the respective pulse lengths of the control signals increase, while their pulse period remains constant. Starting from short pulses not allowing for any overlap with other control signals, the respective pulse lengths increase up to the point where the pulse length is substantially equal to the pulse period of the respective control signal for switching elements SW1 - SW4. In the latter case, respective switching element SW1 - SW4 will be activated (closing the circuit) at almost any given time.

In Fig. 2b, three different instances on the time axis are highlighted by vertical lines. At t=t1, the pulse length of the control signals of switching elements SW1 - SW4 have increased up to one quarter of their pulse period. Thus, voltages V1 - V4 will not overlap one another as they are, save for a different amplitude, exact copies, so to say, of the control signal pulses of switching elements SW1 - SW4. The resulting voltages V5 and V6 do not overlap either. However, the pulses corresponding to voltages V5 and V6 are directly adjacent, so at any given time, either voltage V5 or voltage V6 exhibits a pulse. Accordingly, voltage V7 (which results from summing of voltages V5 and V6) is a concatenation of adjacent pulses. Therefore, voltage V7 could at this instance in time virtually be regarded as a single, continuous pulse, or at least the single voltage pulses cannot effectively be distinguished from one another anymore. Thus, t=t1 represents the last instance where the pumping voltage pulses of the circuit in Fig. 1 do not overlap. This is substantially the situation of Fig. 2a. Note that in this case, voltage V7 is reduced by a factor of four in relation to voltages V1 - V4 (V7 is equivalent to Vb/4). Also, the voltage ripple of V7 is reduced by a factor of four.

The time between t=t1 and t=t2 is characterized by elongated pulses of the control signals of switching elements SW1 - SW4. Couples of two of the four pulses of the control signals will start showing increasing overlap. As a result of the pulses being longer than before t=t1, voltages V5 and V6 comprise overlapping pulses. As a further consequence of this overlap, voltage V7 is now a series of pulses with increasing pulse length over time. Due to the overlap, the amplitude of voltage V7 is only reduced by factor two when both pulses of voltages V5 and V6 overlap. While these pulses do not overlap, the amplitude V7 amounts to one quarter of Vb. It can be noted that the voltage ripple of voltage V7 remains reduced as the difference between a pulse peak and the base line voltage (absence of pulses) is still Vb/4.

Passing t=t2, the pulses of the control signals of switching elements SW1 - SW4 increasingly overlap in triplets. Consequently, the pulses of voltages V5 and V6 are altered. In fact, their pulse amplitude is now Vb (corresponding to the amplitudes of voltages V1 - V4). However, in the absence of pulses, the base voltage remains at Vb/2. Thus, the voltage ripple remains Vb/2. It can be seen that the pulse length of voltages V5 and V6 increases with increasing overlap of their respective summing voltages V1 - V4. Consequently, voltage V7 is a train of voltage pulses with increasing pulse length. The amplitude of these resulting pulses (which correspond to the pumping voltage pulses generated by the circuit depicted in Fig. 1) amounts to 3Vb/4. The voltage base is now set at Vb/2, the ripple still being Vb/4.

Reaching t=t3, all the pulses of the control signals of switching elements SW1 - SW4 will start to increasingly overlap. This means that at some moments, up to four out of four pulses of voltages V1 - V4 will overlap, giving rise to voltage pulses of voltages V5 and V6 of an amplitude of Vb. Again, these resulting voltage pulses will be short as the time of an overlap of four pulses of voltages V1 - V4 is short to begin with. However, with growing pulse lengths of the control signals, the time of overlap will increase and, thus, the resulting pulses of voltages V5 and V6 will be longer, too. Yet again, it can be noted that the base voltage of the pulses referring to voltages V5 and V6 has increased, this time reaching Vb/2. As before, the voltage ripple remains unchanged. Similarly, voltage V7 is a train of voltage pulses of amplitude Vb. In the absence of these pumping voltage pulses, voltage V7 drops to 3Vb/4. The voltage ripple of voltage V7 remains unchanged.

Fig. 2b illustrates some technical benefits of the present disclosure. By operating only on the control signals, the pumping voltage pulses can be adjusted in both their amplitude and their pulse length. This enables an operator to change the characteristics of a laser by merely making changes to the electrical control signals of the pumping circuit without having to pass through a stand-by mode or shut down the laser device temporarily. It should be emphasized that in any case, the resulting voltage ripple is reduced, so additional smoothing capacitors in parallel to the pump are dispensable.

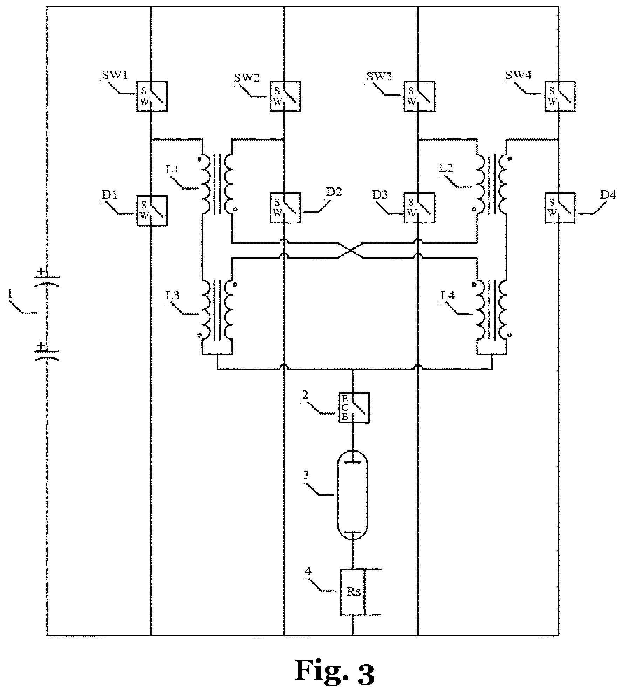

Fig. 3 illustrates another example of a circuit. Generally, the circuit of Fig. 3 is similar to that of Fig. 1. Accordingly, the above explanations apply mutatis mutandis. In particular, the circuit of Fig. 3 features four phase-shifted switching elements, just as the circuit of Fig. 1. However, four pairs of coupled inductors L1, L2, L3 and L4 are used instead of three as in the circuit of Fig. 1. The control signals for controlling SW1, SW2, SW3 and SW4 may be assumed to be those described with reference to the circuit of Fig. 1. However, in the example of Fig. 3, the highest (second) level of summing is not carried out by summing transformers but by coupled inductors having two exit points each. In other words, the windings of the two inductors do not meet at the output side (low side) of the pair of coupled inductors. The pair of coupled inductors hence may not be regarded as an autotransformer. The inductor representing the first phase (associated with switching element SW1) is connected to the first entry point of a pair of coupled inductors (which may also be an autotransformer) L3. The other inductor representing the second phase (associated with switching element SW2) is connected to the first entry point of another pair of coupled inductors L4. The inductor representing the third phase (associated with switching element SW3) is connected to the second entry point of the third pair of coupled inductors L3, whereas the other inductor representing the fourth phase (associated with switching element SW4) is connected to the second entry point of the fourth pair of coupled inductors L4. The output of the pairs of coupled inductors L3 and L4 are then inter-connected to an electric circuit breaker 2, a (light) pump 3 and a current sensor 4, as in the circuit of Fig. 1.

Generally, several different connections among the inductors may be made. For instance, the inductors' orientation may be interchanged as long as the windings of coupled inductors remain opposite. The electric current within a secondary winding may generally be the same as the electric current in the primary winding of a coupled inductor. However, if coupled inductors are directly wire-connected, the current rises according to Kirchhoff s current law. With resulting higher current in the next level of summing operations, special care must be taken to avoid saturation of the magnetic core. Summing elements L1 - L3 in the configuration of Fig. 1 typically have the same core size and material for both summing levels. To compensate higher current in the first summing level, coupled inductors (including autotransformers) may need to have a lower number of turns for their primary and secondary windings. Higher current may be compensated with fewer turns to avoid an increase of the magnetic flux which could result in an oversaturation of the core material. When saturation occurs in an inductive element, there is no longer equal sharing of the electric currents in the sub-circuits, which can lead to a disbalance in load and, in the worst case, to a complete failure of the respective switching element.

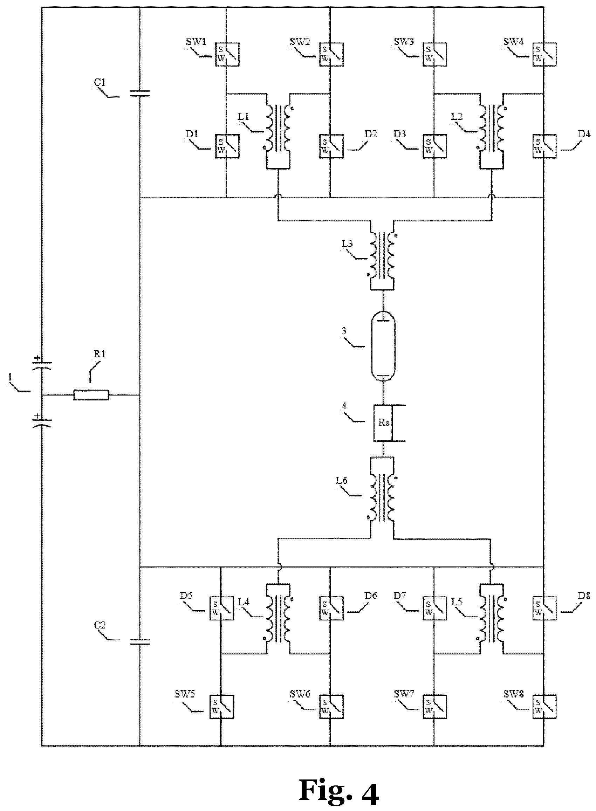

Fig. 4 illustrates a circuit that uses eight phase-shifted switching elements. As in the circuit of Fig. 1, four distinct sub-circuits, each respectively comprising switching elements SW1, SW2, SW3, SW4 and rectifying elements D1, D2, D3, D4, are connected to the positive pole of a capacitor bank. Similar to the circuit of Fig. 1, two levels of summing transformers are connected in between each switching element and rectifying element. The output of the third summing transformer L3 is yet again connected to (light) pump 3 and current sensor 4. Note that in the circuit of Fig. 4 no electric circuit breaker is switched in series with the pump.

Unlike in the circuit of Fig. 1, the other pole of current sensor 4/light pump 3 is not directly connected to the low side of capacitor bank 1, but to another two-level summing cascade including switching elements SW5, SW6, SW7, SW8 and rectifying elements D5, D6, D7, D8. This part of the circuit is symmetrical to the high side of the circuit, comprising an analogous set-up of summing transformers. That is, high and low side parts of the circuit are each similar to the four phase-shifted switching element circuit of Fig. 1 with the key difference being found in the control signals for all switching elements. Instead of two pairs of switching elements, this circuit consists of four pairs that form a highest (second) summing level. As in the example of a four phase-shifted switching element circuit, each pair of switching elements is controlled by control signals shifted by (approximately) half of a switching period. In contrast, each of the phase-shifted control signals within a pair must be shifted by (approximately) an integer multiple of one eighth (e.g., specifically by 1, 2, 3, 5, 6 or 7 eighths) of a switching period from any other switching element from any other pair. The result is a voltage ripple supplied to the pump and/or active medium divided in (approximately) half as compared to the four phased example. Depending on the desired output voltage, the pulse width of the control signals may be varied by operating on the overlap between the voltage pulses. If the capacitor bank voltage is Vb, then the output voltage, i.e., the pumping voltage pulses, comprise(s) pulses from 0 to Vb/8, Vb/8 to 2Vb/8 or even up to 7Vb/8 to Vb.

As in the circuit of Fig. 1, possible failure of a switching element may need to be considered to avoid a total discharge of capacitor bank 1 into pump 3. In the circuit of Fig. 4, capacitor bank 1 consists of two storage capacitors of equal capacitance, thus defining a middle point of the circuit in between them. It is possible that there are more than two capacitors such that the respective joint capacitance of the capacitors to either side of the middle point is equal. The middle point is connected via a balancing resistor R1 to the respective low sides of rectifying elements D1 - D4 and the respective high sides of rectifying elements D5 - D8. Additional capacitors C1 and C2 are switched in parallel to the sub-circuits comprising switching and rectifying elements SW1/D1 - SW4/D4 respectively SW5/D5 - SW8/D8. Without these additional capacitors C1 and C2, if a failure occurred in one of switching elements SW 1-8, (approximately) half of capacitor bank 1 would be discharged through pump 3. Using capacitors C1 and C2, this may be avoided, as only energy stored in either capacitor C1 or capacitor C2 may be discharged into the pump 3 in case of failure. This is much less problematic as the combined capacitance of capacitors C1 and C2 may be 10 times, 50 times or even 100 times lower than the capacitance of capacitor bank 1. Both low and high side sub-circuits may be controlled with the same pulse width control signals (but shifted by (approximately) one eighth of a phase as outlined above). Consequently, the voltage on capacitor C1 is equal to the voltage across capacitor C2. This effect is used to stabilize the middle point of capacitor bank 1 due to controlled balancing through resistor R1.

## Claims

1. Circuit for pumping an active medium of a laser, wherein the circuit is adapted to:
generate pumping voltage pulses (V7) by summing at least two mutually time-shifted voltage pulses (V1, V2, V3, V4, V5, V6); and
apply the pumping voltage pulses to a pump for pumping the active medium of the laser (3).

2. Circuit according to claim 1, wherein summing is performed, at least in part, by means of at least two magnetically coupled inductors (L1, L2, L3, L4, L5), wherein coils of the at least two magnetically coupled inductors preferably comprise mutually opposite windings.

3. Circuit according to claim 1 or 2, wherein the circuit is adapted to generate:
the pumping voltage pulses by summing first (V5) and second (V6) mutually time-shifted voltage pulses;
the first mutually time-shifted voltage pulses by summing third (V1) and fourth (V2) mutually time-shifted voltage pulses; and
the second mutually time-shifted voltage pulses by summing fifth (V3) and sixth (V4) mutually time-shifted voltage pulses.

4. Circuit according to claim 3, wherein:
summing the first and second mutually time-shifted voltage pulses is performed by means of a first pair of magnetically coupled inductors (L3);
summing the third and fourth mutually time-shifted voltage pulses is performed by means of a second pair of magnetically coupled inductors (L1); and
summing the fifth and sixth mutually time-shifted voltage pulses is performed by means of a third pair of magnetically coupled inductors (L2);
wherein respective inductors of each pair of magnetically coupled inductors are directly wire-connected to each other.

5. Circuit according to claim 1 or 2, wherein the circuit is adapted to generate the pumping voltage pulses by:
summing first and second mutually time-shifted voltage pulses by means of a first pair of magnetically coupled inductors; and
summing third and fourth mutually time-shifted voltage pulses by means of a second pair of magnetically coupled inductors;
wherein respective inductors of each pair of magnetically coupled inductors are directly wire-connected to each other.

6. Circuit according to claim 5, wherein all inductors of the first pair and the second pair are directly wire-connected to each other, the circuit further adapted to generate:
the first and the third voltage pulses by summing fifth and sixth mutually time-shifted voltage pulses by means of a third pair of magnetically coupled inductors (L1);
the second and the fourth voltage pulses by summing seventh and eighth mutually time-shifted voltage pulses by means of a fourth pair of magnetically coupled inductors (L2);
wherein:
a first inductor of the third pair is connected to a first inductor of the first pair;
a second inductor of the third pair is connected to a first inductor of the second pair;
a first inductor of the fourth pair is connected to a second inductor of the first pair; and
a second inductor of the fourth pair is connected to a second inductor of the second pair.

7. Circuit according to claim 5, wherein the circuit is further adapted to generate at least one of the first, second, third and fourth mutually time-shifted voltage pulses by summing at least two respective further mutually time-shifted voltage pulses by means of a respective further pair of magnetically coupled inductors, wherein respective inductors of the respective further pair of magnetically coupled inductors are directly wire-connected to each other.

8. Circuit according to one of the preceding claims, wherein the circuit is adapted to generate each of at least two of the mutually time-shifted voltage pulses by partially discharging a source voltage (Vb) into a respective one of at least two magnetically coupled inductors (L1, L2), preferably using a respective separate switching element (SW1, SW2, SW3, SW4) and a respective separate rectifying element (D1, D2, D3, D4), each respective separate switching element further preferably comprising a maximum switching frequency of no more than 100 kHz.

9. Circuit according to one of the preceding claims, wherein the pumping voltage pulses are not applied to a smoothing capacitor switched in parallel to the pump and/or to a smoothing inductor switched in series with the pump.

10. Circuit according to one of the preceding claims, wherein the mutually time-shifted voltage pulses derive from a common voltage source (1), the common voltage source preferably comprising one or more storage capacitors and/or the common voltage source preferably supplying a source voltage (Vb) between 100 and 1500 V.

11. Circuit according to claim 10, further comprising at least one safety element (2) preventing an uncontrolled discharge of the common voltage source into the pump and/or the active medium.

12. Circuit according to claim 11, wherein:
the common voltage source comprises a middle point and at least one storage capacitor to either side of the middle point such that either side of the middle point comprises a same joint capacitance; and
the at least one safety element comprises two RC sub-circuits with at least one common resistive element (R1) connected to the middle point of the common voltage source.

13. Circuit according to one of the preceding claims, wherein the circuit is adapted such that a ratio between a period of the mutually time-shifted voltage pulses and a period of the pumping voltage pulses is an integer multiple, preferably an integer multiple of two or three.

14. Circuit according to one of the preceding claims, wherein the circuit is adapted such that a ratio between an amplitude of the mutually time-shifted voltage pulses and an amplitude of the pumping voltage pulses is an integer multiple, preferably an integer multiple of two or three.

15. A laser comprising a circuit according to one of the preceding claims.
